(19) Europäisches Patentamt
European Patent Office
Office européen des brevets

(11) EP 0 895 127 A2

(12) **EUROPEAN PATENT APPLICATION**

(43) Date of publication:
**03.02.1999 Bulletin 1999/05**

(51) Int. Cl.$^6$: **G03F 7/004**

(21) Application number: **98114468.6**

(22) Date of filing: **31.07.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **01.08.1997 JP 207709/97**
**23.10.1997 JP 290677/97**

(71) Applicant:
**MITSUBISHI CHEMICAL CORPORATION**
**Chiyoda-ku, Tokyo 100-0005 (JP)**

(72) Inventors:
- **Yoshihara, Junji,**
**c/o Mitsubishi Chemical Corp.**
**Kitakyushu-shi, Fukuoka 806 (JP)**
- **Nakano, Kouji,**
**c/o Mitsubishi Chemical Corp.**
**Kitakyushu-shi, Fukuoka 806 (JP)**
- **Kusumoto, Tadashi,**
**c/o Mitsubishi Chemical Corp.**
**Kitakyushu-shi, Fukuoka 806 (JP)**
- **Kawase, Yasuhiro,**
**c/o Mitsubishi Chemical Corp.**
**Kitakyushu-shi, Fukuoka 806 (JP)**

(74) Representative:
**TER MEER STEINMEISTER & PARTNER GbR**
**Mauerkircherstrasse 45**
**81679 München (DE)**

(54) **Photoresist composition**

(57) A photoresist composition comprising:

(1) an alkali-soluble resin (A),
(2) a radiation sensitive compound (B), and
(3) at least one member selected from the following compounds (C) and (D), as an additive:

Compound (C): an alkali-decomposable compound which decomposes in the presence of an alkali to form water-soluble compounds; and
Compound (D): a compound of the following formula (I):

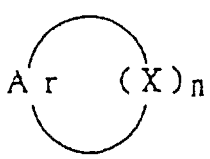

(I)

wherein X is $-C(R^1)_2-$, -O-, =C=O, $=C(O(R^1))_2$, =S, =SO or $=SO_2$, $R^1$ is a hydrogen atom or a $C_{1-4}$ alkyl group, n is an integer of from 2 to 6, the plurality of X may be the same or different, and Ar is a $C_{5-14}$ aryl group which may be substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when Ar has two or more substituents, such substituents may be the same or different.

EP 0 895 127 A2

## Description

The present invention generally relates to a photoresist composition which is sensitive to radiations. Particularly, it relates preferably to a positive photoresist composition comprising an alkali-soluble resin, a radiation sensitive compound and a solvent.

Integrated circuits have been highly integrated year after year. For example, in the case of dynamic random access memory (DRAM), production of DRAM having a memory capacity as large as 64 M bits is about to start on a commercial basis. Accordingly, the requirements for the photolithography technology essential for the production of such integrated circuits have been stricter year after year. For example, for the production of 4 M bits DRAM, a lithography technique of a 0.8 μm level is required. Whereas, for the production of 16 M and 64 M bits DRAMs, lithography techniques of 0.5 μm or 0.35 μm level are said to be required, respectively.

Various proposals have been made with respect to photolithography techniques capable of accomplishing such extremely fine processing. For example, from the optical aspect, improvement of the resolving power can be accomplished by high performance of a reduction projection lens, for example, by increasing NA of the lens. However, due to a practical restriction in the production of the lens, there is a limit in securing an adequate exposure area, and there is a difficulty such that the depth of focus decreases in order to improve the resolving power. Accordingly, it has become important to apply various super resolving techniques, and a phase shift method, an oblique incident exposure method, a pupil filter method and a combination thereof have been studied. By a method of utilizing a phase shift mask, the resolving power and the depth of focus can be improved. However, due to a limitation in the pattern and a substantial difficulty in practical operation for mask production, this method has not yet been practically applied except for a certain process. By the oblique incident exposure, the depth of focus can be improved, but from a difficulty in the hardware, the exposure tends to be low, and the sensitivity of the resist tends to be inadequate. Further, a multilayer process such as a three layer resist process has been proposed, but such a process is not practical from the viewpoint of mass production of integrated circuits. Thus, none of such proposals presents a process excellent in mass productivity which is comparable to a conventional single layer process. Accordingly, it has been strongly desired to develop a photoresist composition whereby an adequately high resolving power can be obtained by a single layer process.

Further, for industrial production of integrated circuits, various factors have become important, in addition to the resolving power, along with the progress in dimensional reduction by micro fabrication. For mass production of integrated circuits, it is necessary that the throughput of the micro fabrication process is high, and it is also important that the photoresist has high sensitivity. In general, the resolution and the sensitivity are mutually contradictory, and a so-called high resolution resist useful for advanced micro fabrication in recent years, has low sensitivity. Accordingly, it has recently become very important to improve the sensitivity of a photoresist from the viewpoint of mass production of integrated circuits, although it is of course still demanded to improve the resolution. Further, it is also important that the cross-sectional shape of the resist after development is good. It is common to protect non-etching portions by a resist film pattern prepared by a photolithography process, and to remove unnecessary portions by etching or sputtering. At that time, if, in the cross-sectional shape of the resist, the surface portion of the pattern top bulges towards both sides to form a so-called T-top shape where the shape of the pattern becomes a mushroom or letter T form, or to form an inverted taper shape of inverted trapezoid where the upper portion of the pattern is wider than the lower portion, or if a flare or bite forms at the interface between the resist and the wafer substrate, a predetermined dimension can not be obtained by such etching. Further, a standing wave will form so that there will be a variation in the light intensity due to multiple reflection of light in the resist film, i.e. there will be a distribution or variation in the decomposition rate of the photosensitive material, and there will be accordingly a variation in the dissolving rate of the resist in the developer, whereby the pattern will have a waved shape in its cross-section. If a standing wave forms in the cross-section of the pattern, it will be difficult to control the dimension in the micro fabrication process, such being undesirable for the production of semiconductors.

Further, in the micro fabrication process for integrated circuits, the depth of focus has become important, which is an allowable range for deviation from the focus within which an image at the best focus of an optical image may remain to be an allowable image. In conventional 1M bit DRAM, the capacitance used to be of one-dimensional structure. However, since 4M bit DRAM, the structure has changed to a three-dimensional cell structure so-called a trench structure or a stack structure. Further, in addition to miniaturization in recent years, there has been a progress in the multilayer structure for the production of semiconductor devices to assist high integration, and an increase of the depth of focus in a photolithography process is strongly desired also to cope with a problem of a topology in the production of such devices.

For the foregoing purposes, various studies have been made with respect to the composition of a photoresist composition, and various proposals have been made also with respect to the additives. In general, when a phenolic hydroxyl group is introduced to an additive to improve the hydrophilicity, the sensitivity will be improved, but the performance tends to be low, since it tends to be readily soluble. On the other hand, if the hydrophobic property is increased, although the sensitivity tends to be low, the performance will not decrease substantially, and, in a rare case, may even

improve. For example, various proposals have been made with respect to a compound having a phenolic hydroxyl group. JP-A-4-11260 discloses a positive type photoresist composition comprising a novolak resin, a quinonediazide compound and a trisphenol compound. Due to the solubility of these compounds in an alkali developer, the sensitivity has been improved, but in either case, improvement in the performance is not sufficient. Further, JP-A-5-323598 discloses that a resolving power can be improved by using benzpinacol as an additive, but deterioration of the sensitivity is substantial, and a standing wave is likely to form, such being undesirable from the viewpoint of mass production of integrated circuits.

Further, JP-A-9-114090 discloses addition of a nitrogen-containing heterocyclic compound of a specific structure to a photoresist composition. However, such a compound is an amine compound or a hydroxyamine compound. Accordingly, if added to a photoresist composition, it may adversely affect the photoresist composition, such being undesirable.

Under these circumstances, it is an object of the present invention to provide a photoresist composition which has high sensitivity and high resolution and is excellent in forming a rectangular shape and which provides an increased depth of focus and a large exposure margin (E0/Ec being large) and is excellent also in the storage stability.

In order to solve such problems, the present inventors have conducted various studies and as a result, have found that by adding an alkali-decomposable compound or a compound having a specific structure, as an additive, to a photoresist composition, it is possible to obtain a composition which has high sensitivity and high resolution with the rectangularity remarkably improved and which provides an increased depth of focus and a large exposure margin (E0/Ec being large) and has the storage stability improved.

Namely, the present invention provides a photoresist composition comprising:

(1) an alkali-soluble resin (A),
(2) a radiation sensitive compound (B), and
(3) at least one member selected from the following compounds (C) and (D), as an additive:

Compound (C): an alkali-decomposable compound which decomposes in the presence of an alkali to form water-soluble compounds; and
Compound (D): a compound of the following formula (I):

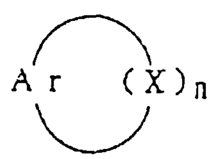

(I)

wherein X is $-C(R^1)_2-$, -O-, =C=O, $=C(O(R^1))_2$, =S, =SO or $=SO_2$, $R^1$ is a hydrogen atom or a $C_{1-4}$ alkyl group, when a plurality of $R^1$ are present, they may be the same or different, n is an integer of from 2 to 6, the plurality of X may be the same or different, and Ar is a $C_{5-14}$ aryl group which may be substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when Ar has two or more substituents, such substituents may be the same or different.

Now, the present invention will be described in detail with reference to the preferred embodiments.

It is the feature of the present invention to incorporate the above compound (C) or the above compound (D) as a specific additive to a photoresist composition. In the present invention, by the addition of the alkali-decomposable compound (C), it is possible to substantially improve the sensitivity over a case where no such a compound is added, while maintaining the good rectangularity, the high resolution and the large depth of focus without a standing wave.

The alkali-decomposable compound (C) is one which is decomposable to two or more compounds by a usual alkali developer, whereby at least a part of the decomposed compounds shows water solubility. As such an alkali-decomposable compound (C), an ester or an acid anhydride may, for example, be mentioned, whereby a decomposed product formed by the hydrolysis thereof shows water solubility. However, the compound (C) is not limited to such a specific example and may be one which, upon decomposition, becomes a water soluble compound by virtue of a substituent showing water solubility formed by the decomposition, such as a hydroxyl group, a carboxyl group, an amine group, a sulfonate group, a sulfonamide group or a salt thereof.

As a specific example of the alkali-decomposable compound (C) to be used in the present invention, a compound of the following formula (II) or (III) may, for example, be mentioned.

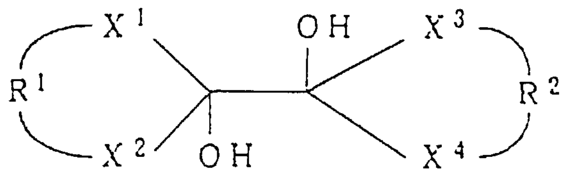

(II)

In the above formula (II), each of $R^1$ and $R^2$ is a $C_{5-14}$ aryl group which may be substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when $R^1$ or $R^2$ have two or more substituents, such substituents may be the same or different. Among substituents attached to $R^1$ or $R^2$, preferred are a hydrogen atom, a hydroxyl group, a halogen atom, a $C_{1-4}$ alkyl group, a $C_{3-10}$ cycloalkyl group, a $C_{6-10}$ aryl group, a $C_{7-14}$ aralkyl group, a $C_{2-5}$ alkylcarbonyloxy group, a $C_{7-11}$ arylcarbonyloxy group, a $C_{1-4}$ alkylsulfonyloxy group, a $C_{6-10}$ arylsulfonyloxy group, a $C_{1-4}$ alkoxysulfonyl group, and a $C_{1-4}$ aryloxysulfonyl group. Among them, particularly preferred are a hydrogen atom and a $C_{1-4}$ alkyl group, a $C_{1-4}$ alkoxy group, a $C_{2-5}$ alkylcarbonyloxy group or a $C_{7-11}$ arylcarbonyloxy group, in which hydrogen atoms on the substituent may be substituted by halogen atoms. The $C_{1-4}$ alkyl group may, for example, be a methyl group, an ethyl group, a propyl group or a butyl group. The $C_{1-4}$ alkoxy group may, for example, be a methoxy group, an ethoxy group, a propoxy group or a butoxy group. The $C_{2-5}$ alkylcarbonyloxy group may, for example, be an acetoxy group, a propionyloxy group, a butyronyloxy group or a pentylonyloxy group. The $C_{7-11}$ arylcarbonyloxy group may, for example, be a benzoyloxy group, a p-methylbenzoyloxy group or a p-methoxybenzoyloxy group. The $C_{6-10}$ arylsulfonyloxy group may, for example, be a benzenesulfonyloxy group or a p-toluenesulfonyloxy group. The halogen atom may, for example, be an atom of fluorine, chlorine, bromine or iodine. Among them, a hydrogen atom and a $C_{1-2}$ alkyl, alkoxy or alkylcarbonyloxy group in which hydrogen atoms on the substituent may be substituted by halogen atoms, are preferred. More preferred are a hydrogen atom and a methyl or methoxy group. Further, the number of substituents which each of $R^1$ and $R^2$ independently has, is preferably an integer of from 0 to 2. Each of $X^1$ to $X^4$ is $-C(R^3)_2-$, -O-, C=O, $=C(O(R^3))_2$, -S-, =SO, $=SO_2$ or $=NR^3$. $R^3$ is a hydrogen atom or a $C_{1-4}$ alkyl group. When a plurality of $R^3$ are present, they may be the same or different, $X^1$ to $X^4$ may be the same or different. The $C_{1-4}$ alkyl group may, for example, be a methyl group, an ethyl group, a propyl group or a butyl group. Among them, each of $X^1$ to $X^4$ is preferably =C=O, $=C(O(R^3))_2$ or =SO, more preferably =C=O or $=C(OH)_2$. As a specific example of such a compound of the formula (II), 2,2'-dihydroxy-2,2'-biindane-1,1',3,3'-tetoron or 2,2',3,3,3',3'-hexahydroxy-2,2'-biindane-1,1'-dione is preferred.

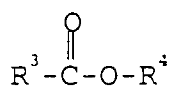

(III)

In the formula (III), each of $R^3$ and $R^4$ is a $C_{1-4}$ alkyl group or a $C_{5-14}$ aryl group, which may be substituted by a hydroxyl group, a halogen atom, a nitro group, a cyano group, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when $R^3$ or $R^4$ has two or more substituents, such substituents may be the same or different. Among substituents attached to $R^3$ or $R^4$, preferred are a hydrogen atom, a hydroxyl group, a halogen atom, a $C_{1-4}$ alkyl group, a $C_{3-10}$ cycloalkyl group, a $C_{6-10}$ aryl group, a $C_{7-14}$ aralkyl group, a $C_{2-5}$ alkylcarbonyloxy group, a $C_{7-11}$ arylcarbonyloxy group, a $C_{1-4}$ alkylsulfonyloxy group, a $C_{6-10}$ arylsulfonyloxy group, a $C_{1-4}$ alkoxysulfonyl group and a $C_{1-4}$ aryloxysulfonyl group. Among them, preferred are a hydrogen atom and a $C_{1-4}$ alkyl group, a $C_{1-4}$ alkoxy group, a $C_{2-5}$ alkylcarbonyloxy group or a $C_{7-11}$ arylcarbonyloxy group, in which hydrogen atoms on the substituent may be substituted by halogen atoms. The $C_{1-4}$ alkyl group may, for example, be a methyl group, an ethyl group, a propyl group or a butyl group. The $C_{1-4}$ alkoxy group may, for example, be a methoxy group, an ethoxy group, a propoxy group or a butoxy group. The $C_{2-5}$ alkylcarbonyloxy group may, for example, be an acetoxy group, a propionyloxy group, a butyronyloxy group or a pentylonyloxy group. The $C_{7-11}$ arylcarbonyloxy group may, for example, be a benzoyloxy group, a p-methylbenzoyloxy group or a p-methoxybenzoyloxy group. The $C_{6-10}$ arylsulfonyloxy group may, for example, be a benzenesulfonyloxy group or a p-toluenesulfonyloxy group. The halogen atom may, for example, be an atom of fluorine, chlorine, bromine or iodine. Among them, a hydrogen atom and a $C_{1-2}$ alkyl, alkoxy or alkylcarbonyloxy group in which hydrogen atoms on the substituent may be substituted by halogen atoms, are preferred. More

preferred are a hydrogen atom and a methyl or methoxy group. Further, the number of substituents which each of $R^3$ and $R^4$ independently has, is preferably an integer of from 0 to 2.

$R^3$ is preferably 1, 1-dimethyl-propyl, 1,1-dimethyl-ethyl, 1-methyl-ethyl, propyl, methyl, phenyl, 4-methyl-phenyl or styryl. $R^4$ is preferably 4-nitro-phenyl or 4-cyano-phenyl. In the formula (III), the most preferable compound is 4-nitrophenyl acetate or 4-cyanophenyl acetate.

Such an alkali-decomposable compound (C) is added to a photoresist composition, followed by exposure through a mask, baking and then development treatment with an alkaline developer, whereby the alkali-decomposable compound (C) is hydrolyzed and selectively decomposed to form water-soluble compounds, by penetration of the alkali developer in the development process of the resist, only at an exposed-portion, while it undergoes no decomposition at a non-exposed portion. For example, with 2,2'-dihydroxy-2,2'-biindane-1,1', 3,3'-tetoron or a 2,2',3,3,3',3'-hexahydroxy-2,2'-biindane-1,1'-dione derivative, the C-C bond portion of the 1,2-diol structure is selectively decomposed to form a 1,2,3-triketohydrindene hydrate derivative and a 1,3-diketo-hydrindole derivative. The 1,2,3-triketohydrindene hydrate derivative itself is water-soluble However, the 1,3-diketo-hydrindole derivative formed at the same time changes into a more water-soluble compound under an alkaline condition, whereby the dissolving rate of the resist in an alkali developer at the exposed portion during developing is improved over a case where no such a compound is incorporated. Accordingly, the sensitivity of the resist is improved, and at the same time, at the non-exposed portion, film reduction scarcely takes place mainly due to the dissolution suppressing effect of the photosensitive agent, whereby the difference in the dissolving rate between the exposed portion and the non-exposed portion increases to bring about a high contrast, so that the depth of focus will be deep, and the rectangularity will be good with high resolution.

Further, such an alkali-decomposable compound (C) is preferably a compound which, when decomposed by an alkali, forms at least a compound of the after-mentioned formula (I), whereby the effect of the present invention can more efficiently be obtained.

It is preferred that the weight average molecular weight (Mw) of at least one compound among water-soluble compounds formed by the decomposition of the alkali-decomposable compound (C), is $30 \leqq Mw \leqq 1000$, more preferably $50 \leqq Mw \leqq 500$, particularly preferably $100 \leqq Mw \leqq 300$. Further, it is preferred that the weight average molecular weights of all water-soluble compounds formed by the decomposition of the alkali-decomposable compound (C) are within the above-mentioned range.

Further, in order to obtain the effect of the present invention as described above, the alkali-decomposable compound (C) is required to be readily decomposed in an alkali developer. When it is added to 1,000 times by weight of a 2.38% tetramethylammonium hydroxide (TMAH) aqueous solution at 23°C, it is preferred that at least 3 wt% of its initially added amount decomposes in 60 seconds. More preferably, at least 10 wt%, particularly preferably at least 30 wt%, of the initial amount decomposes in 60 seconds.

In the present invention, the method for measuring the amount of decomposition of the alkali-decomposable compound is as follows.

Firstly, 0.010 g of the alkali-decomposable compound is added to 10.00 g of a 2.38% tetramethylammonium hydroxide aqueous solution at 23°C with stirring, and after stirring for 60 seconds, the mixture is subjected to measurement of the amount of decomposition. The measurement of the amount of decomposition can be carried out, for example, by NMR, HPLC or an ultraviolet absorption spectrum method. In any method, the measurement is carried out with respect to the alkali-decomposable compound before and after the decomposition. Paying a particular attention to the peak which quantitatively changes along with the decomposition of the alkali-decomposable compound, and, if necessary, using a calibration curve prepared beforehand, the amount of decomposition is obtained from the difference in the peak areas (the peak heights in the case of an ultraviolet ray absorption spectrum method) before and after the decomposition. In a case where NMR is employed, decomposition of the alkali-decomposable compound may be carried out for 60 seconds by means of a heavy water solution containing 2.38% of tetramethylammonium hydroxide. The present inventors used, as NMR, NMR (nuclear magnetic resonance measuring apparatus: AL-400 400 MHz) manufactured by Jeol Co., as HPLC, a high performance liquid chromatography (UV-8020, CCPS and CO-8020) manufactured by TOSOH CORPORATION, and as a ultraviolet ray absorption spectrum meter, a spectrum photometer (U-2000) manufactured by Hitachi Ltd.

As the alkali-decomposable compound (C) for the present invention, the above-mentioned compounds may be used alone or in combination as a mixture.

Further, with respect to its blend ratio to the total solid content of the photoresist composition i.e. $[C/(A+B+C)] \times 100(\%)$, the upper limit is preferably 10 wt%, particularly preferably 5 wt%, and the lower limit is preferably 0.1 wt%, particularly preferably 0.4 wt%, still further preferably 1 wt%. If this blend ratio is too small, no adequate effects can be obtained, and if it is too much, an adverse effect tends to be given to the heat resistance, such being undesirable.

Further, the present inventors have found that by adding a compound having a specific structure as an additive to a photoresist composition, it is possible to substantially improve the sensitivity as compared with a case where no such a compound is added, while maintaining a good rectangularity, a small standing wave and a high resolution. Such

an additive is a compound (D) of the following formula (I). It is believed that as the compound (D) becomes water-soluble under an alkaline developing condition, the solubility of the photoresist during the development increases, whereby an effect such as substantial improvement of the rectangularity can be obtained.

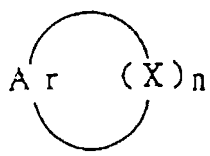 (I)

wherein X is $-C(R^1)_2-$, -O-, =C=O, $=C(O(R^1))_2$, =S, =SO or $=SO_2$, $R^1$ is a hydrogen atom or a $C_{1-4}$ alkyl group, when a plurality of $R^1$ are present, they may be the same or different, n is an integer of from 2 to 6, the plurality of X may be the same or different, and Ar is a $C_{6-14}$ aryl group which may be substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when Ar has two or more substituents, such substituents may be the same or different.

Among substituents attached to Ar, preferred are a hydrogen atom, a hydroxyl group, a halogen atom, a $C_{1-4}$ alkyl group, a $C_{3-10}$ cycloalkyl group, a $C_{6-10}$ aryl group, a $C_{7-14}$ aralkyl group, a $C_{2-5}$ alkylcarbonyloxy group, a $C_{7-11}$ arylcarbonyloxy group, a $C_{1-4}$ alkylsulfonyloxy group, a $C_{6-10}$ arylsulfonyloxy group, a $C_{1-4}$ alkoxysulfonyl group, and a $C_{1-4}$ aryloxysulfonyl group. Among them, preferred are a hydrogen atom and a $C_{1-4}$ alkyl group, a $C_{1-4}$ alkoxy group, a $C_{2-5}$ alkylcarbonyloxy group or a $C_{7-11}$ arylcarbonyloxy group, wherein hydrogen atoms on the substituent may be substituted by halogen atoms. The $C_{1-4}$ alkyl group may, for example, be a methyl group, an ethyl group, a propyl group or a butyl group. The $C_{1-4}$ alkoxy group may, for example, be a methoxy group, an ethoxy group, a propoxy group or a butoxy group. The $C_{2-5}$ alkylcarbonyloxy group may, for example, be an acetoxy group, a propionyloxy group, a butyronyloxy group or a pentylonyloxy group. The $C_{7-11}$ arylcarbonyloxy group may, for example, be a benzoyloxy group, a p-methylbenzoyloxy group or a p-methoxybenzoyloxy group. The $C_{6-10}$ arylsulfonyloxy group may, for example, be a benzenesulfonyloxy group or a p-toluenesulfonyloxy group. The halogen atom may, for example, be an atom of fluorine, chlorine, bromine or iodine. Among them, a hydrogen atom and a $C_{1-2}$ alkyl, alkoxy or alkylcarbonyloxy group in which hydrogen atoms on the substituent may be substituted by halogen atoms, are preferred. More preferred are a hydrogen atom and a methyl or methoxy group. Further, the number of substituents excluding X, which Ar has, is preferably an integer of from 0 to 3, more preferably from 0 to 1.

X is $-C(R^1)_2-$, -O-, C=O, $=C(O(R^1))_2$, =S, =SO or $=SO_2$. $R^1$ is a hydrogen atom or a $C_{1-4}$ alkyl group, and n is an integer of from 2 to 6. Here, a plurality of X may be the same or different. The $C_{1-4}$ alkyl group may, for example, be a methyl group, an ethyl group, a propyl group or a butyl group. As n, preferred is $3 \leqq n \leqq 6$, and more preferred is $3 \leqq n \leqq 4$, and a plurality of X may be the same or different. Among these X, preferred are $-C(R^1)_2-$, -O-, =C=O and $=C(O(R^1))_2$.

Among these compounds (D), specific examples of preferred compounds include 5-chloro-1-indanone, 4-hydroxy-indanone, 5-hydroxy-1-tetralone, 6-bromo-2-tetralone, 2-chomaranone, 4-chromanone, phthalic anhydride, 3-hydroxy-phthalic anhydride, homophthalic anhydride, 1,2,3-indantrione, 1,2,3-indantrione monohydrate (ninhydrin), 5-chloro-1,3-benzodioxole, 6-hydroxy-1,3-benzoxathiol-2-one, 2-carboxybenzaldehyde, 2,2-dihydroxy-5-methoxy-1,3-indandione hydrate, 3H-1,2-benzodithiol-3-one, 2,5-dihydroxyphenylacetic-γ-lactose, 3H-1,2-benzothiol-3-one-1,1-dioxide, 1,4-benzodioxan, 1,3-benzodioxole, 1-benzosuberone, 1-tetralone, dihydrocoumarin, 2,3-dihydro-benzofuran, 1-indanone, and 1,3-indandione.

Among them, most preferred is a compound wherein X is =C=O or $=C(O(R^1))_2$. As a specific example of such a compound, 1,2,3-indantrione, 1,2,3-indantrione monohydrate or 2,2-dihydroxy-5-methoxy-1,3-indandione hydrate is most preferred.

Such a compound (D) is preferably a water-soluble compound at $pH \leqq 7$ or a water-insoluble compound, because if an alkaline water-soluble compound is added as an additive to the photoresist composition, the photoresist composition itself is likely to be adversely affected, e.g. to be crosslinked. Accordingly, the compound (D) is preferably not an alkaline water-soluble compound.

As the compound (D) for the present invention, the compounds of the above formula (I) may be used alone or in combination as a mixture of a plurality of different types of compounds having different structures.

Further, with respect to the blend ratio of the compound (D) to the total solid content of the photoresist composition ($[D/(A+B+D)] \times 100$ (%)), the upper limit is preferably 20 wt%, and the lower limit is preferably 0.1 wt%. Particularly preferably, the upper limit is 10 wt%, and the lower limit is 0.4 wt%, more preferably 1 wt%. If the blend ratio is too small, its effect tends to be inadequate, and if it is too much, the heat resistance tends to be adversely affected, such being undesirable.

Further, it is preferred that an exposure range exists in which the dissolving rate at a dissolving site during

development of the photoresist composition containing the alkali-decomposable compound (C) or the compound (D), is at least 1.05 times, preferably at least 1.1 times, the dissolving rate of the corresponding composition in which the alkali-decomposable compound (C) or the compound (D) is not incorporated. The method for measuring the dissolving rate is as follows.

A photoresist composition having the alkali-decomposable compound (C) or the compound (D) incorporated, and a photoresist composition (a comparative photoresist composition) having the same composition except that the alkali-decomposable compound (C) or the compound (D) is not incorporated, are, respectively, coated on silicon wafers by a spin coater and heated on a hot plate of 90°C for 60 seconds to remove the solvent and to form a photoresist coating film having a thickness of 1.07 μm. This film is subjected to exposure by changing the exposure from 20 msec to 2,000 msec by an i-line stepper (NA=0.50) manufactured by Nikon K.K. and then developed by immersing it in a 2.38% tetramethylammonium hydroxide aqueous solution at 23°C by means of a dissolving rate measuring apparatus (Model-780MK-2) manufactured by Linthotech Japan, whereby the dissolving rate at a dissolving site (an exposed portion in the case of a positive, or a non-exposed portion in the case of a negative), is measured. The measurement of the dissolving rate is carried out usually within 200 sec. When the dissolving rates of the respective photoresist compositions at various exposures, are measured, as mentioned above, it is preferred that there exists at least one exposure at which the dissolving rate of the photoresist composition of the present invention (containing the alkali-decomposable compound (C) or the compound (D)) exposed with a certain exposure, is at least 1.05 times the dissolving rate of the comparative photoresist composition exposed with the same exposure.

When the two compositions were compared with respect to the minimum exposure required to remove the resist coating film as far as to the substrate by developing, it was found that with the photoresist composition having the alkali-decomposable compound (C) or the compound (D) incorporated, the time required for completely dissolving the resist coating film by developing, was short, and the developing rate (Å/sec) was high, as compared with the resist coating film wherein the alkali-decomposable compound (C) or the compound (D) was not incorporated.

As the alkali-soluble resin (A) to be used in the present invention, a novolak resin, a polyhydroxystyrene or its derivative, or a styrene-maleic anhydride copolymer, may, for example, be specifically mentioned. Preferably, a novolak resin, a polyhydroxystyrene or its derivative is used, and particularly preferably, a novolak resin is used.

The novolak resin can be produced by mixing and heating for polycondensing a monomer component, such as phenol, an alkylphenol such as o-cresol, m-cresol, p-cresol, 3-ethylphenol, 2,5-xylenol or 3,5-xylenol, an alkoxy or aryloxy phenol such as 2-methoxyphenol, 4-methoxyphenol or 4-phenoxyphenol, a naphthol such as α-naphthol, β-naphthol or 3-methyl-α-naphthol, or a polyhydroxybenzene such as 1,3-dihydroxybezene, 1,3-dihydroxy-2-methylbenzene, 1,2,3-trihydroxybenzene, 1,2,3-trihydroxy-5-methylbenzene or 1,3,5-trihydroxybenzene, with an aliphatic aldehyde or its precursor such as formaldehyde, acetaldehyde, paraformaldehyde, paraldehyde or trioxane, an aromatic aldehyde such as benzaldehyde, p-hydroxybenzaldehyde or o-hydroxybenzaldehyde, or a carbonyl compound such as an alkyl ketone such as acetone, using e.g. hydrochloric acid, sulfuric acid, oxalic acid or p-toluene sulfonic acid, as a catalyst. Among them, preferred is a novolak resin produced by mixing and heating for polycondensing one or more of m-cresol, p-cresol and 2,5-xylenol, as the monomer component, with one or more of formaldehyde, acetaldehyde, paraldehyde and p-hydroxybenzaldehyde, using hydrochloric acid, oxalic acid or the like, as the catalyst. Particularly preferred is the one produced by mixing and heating for polycondensing m-cresol, p-cresol and/or 2,5-xylenol, with formaldehyde, with formaldehyde and acetaldehyde, or with formaldehyde and paraldehyde, using hydrochloric acid, oxalic acid or the like as the catalyst, whereby improvement in the resolving power is particularly remarkable. The weight average molecular weight, calculated as polystyrene (hereinafter referred to simply as the molecular weight), of such a novolak resin is preferably at most 30,000, more preferably at most 20,000, preferably at least 2,500, more preferably at least 2,900. If the molecular weight is too low, deterioration of the heat resistance will be remarkable, and if it is too high, deterioration of the sensitivity will be remarkable, such being undesirable for stabilized production of integrated circuits.

The polyhydroxystyrene or its derivative can be produced by polymerizing a hydroxystyrene derivative such as 4-hydroxystyrene, 3-methyl-4-hydroxystyrene or 3-chloro-4-hydroxystyrene.

If necessary, the obtained alkali-soluble resin may further be reduced with e.g. hydrogen to lower light absorption in a short wavelength range. The aromatic compound monomer to be used for producing such an alkali-soluble resin, may have a substituent such as a halogen group, a nitro group or an ester group, so long as such a substituent presents no adverse effect to the present invention.

The radiation sensitive compound (B) to be used in the present invention, may, for example, be a photo active compound containing an orthoquinonediazide group.

The photo active compound containing an orthoquinonediazide group is preferably an orthoquinonediazide type photo active compound such as an ester or an amide of 1,2-benzoquinonediazide-4-sulfonic acid, 1,2-naphthoquinonediazide-4-sulfonic acid or 1,2-naphthoquinonediazide-5-sulfonic acid. Specifically, it may, for example, be an ester of 1,2-benzoquinonediazide-4-sulfonic acid, 1,2-naphthoquinonediazide-4-sulfonic acid or 1,2-naphthoquinonediazide-5-sulfonic acid, with a polyhydroxyalkyl compound such as glycerol or pentaerythritol, or with a polyhydroxyaromatic

compound such as a novolak resin, bisphenol A, a gallic acid ester, kelcetine, morin or polyhydroxybenzophenone. Such photo active compounds may be used alone or in combination of two or more of them. Among them, preferred is a 1,2-naphthoquinonediazide-5-sulfonic acid ester of a novolak resin or polyhydroxybenzophenone. The molecular weight of the novolak resin to be used here, is preferably from 400 to 3,000, more preferably from 500 to 2,000. As a particularly preferred radiation sensitive compound, 1,2-naphthoquinonediazide-5-sulfonic acid ester of a novolak resin produced by polycondensing m-cresol as the monomer component, with one or more of formaldehyde, acetaldehyde and 4-hydroxybenzaldehyde, or a 1,2-naphthoquinonediazide-5-sulfonic acid ester of 2,3,4-trihydroxybenzophenone, 2,3,4,4'-tetrahydroxybenzophenone or 2,3,4,2',4'-pentahydroxybenzophenone, may be mentioned. A preferred range of the degree of substitution by esterification of hydroxy groups of such a photo active compound varies depending upon the type of the photo active compound. With respect to the esterification product of a novolak resin, the degree of substitution is preferably at least 20%, more preferably at least 25%, preferably at most 80%, more preferably at most 70%. With respect to the esterification product of a polyhydroxybenzophenone, the degree of substitution is preferably at least 40%, more preferably at least 50%, preferably at most 95%, more preferably at most 90%. If this degree of substitution is too low, the resolving power of the photoresist composition deteriorates, and if it is too high, deterioration of the sensitivity tends to be substantial, such being undesirable. Further, a naphthoquinonediazide sulfonic acid ester of a compound having a phenolic hydroxyl group, as disclosed in e.g. JP-A-2-269351 or JP-A-3-48249, may preferably be used as the photo active compound.

The photoresist composition of the present invention is prepared usually by dissolving it in a solvent. The solvent to be used is not particularly limited so long as it is a solvent commonly used for this purpose. It may, for example, be methyl lactate, ethyl lactate, a glycolic acid ester derivative such as ethyl glycolate, ethylcellosolve acetate, methylcellosolve acetate, a glycol ether ester derivative such as propylene glycol monomethyl ether acetate, a ketone ester such as methyl pyruvate or ethylpyruvate, an alkoxy carboxylic acid ester such as methyl 3-methoxy-propionate, ethyl 3-ethoxy-propionate or methyl 3-ethoxy-propionate, a ketone derivative such as acetyl acetone, cyclopentanone, cyclohexanone or 2-heptanone, a ketone ether derivative such as diacetone alcohol methyl ether, a ketone alcohol derivative such as acetol or diacetone alcohol, an amide derivative such as dimethylacetamide or dimethylformamide, or an ether derivative such as anisole or diethylene glycol dimethyl ether. Further, a solvent mixture thereof may be employed. If necessary, a solvent mixture having xylene, butyl acetate or $\gamma$-butyrolactone incorporated, may be employed. Among them, the mixture solvent containing methyl 3-methoxypropionate, ethyl lactate, or ethyl lactate as the main component, is preferably employed in view of the storage stability, uniformity of the film, the safety or the handling efficiency. Particularly preferably, methyl 3-methoxypropionate, methyl 3-ethoxypropionate, 2-heptanone, or a solvent mixture of ethyl lactate with propylene glycol monomethyl ether acetate or butyl acetate, is employed.

In the photoresist composition of the present invention, the proportion of the radiation sensitive compound to the alkali-soluble resin is usually from 0.0025 to 10 times by weight, preferably 0.01 to 5 times by weight, most preferably from 0.1 to 2 times by weight. Further, the concentration of the alkali-soluble resin in the photoresist composition of the present invention containing a solvent is usually from 1 to 40 wt%, and the concentration of the radiation-sensitive compound is usually from 0.1 to 20 wt%.

Further, to the photoresist composition of the present invention, a surfactant may be added to improve the coating property. It is particularly preferred to incorporate a fluorine type surfactant. Such a surfactant may be added preferably in an amount of at most 1,000 ppm, more preferably at most 200 ppm, based on the photoresist liquid. Further, a light-absorbihg material may be added to reduce the influence of a scattered light from the substrate, or a sensitizer or the like may further be added to improve the sensitivity.

To prepare the photoresist composition from the various constituting components as described above, the alkali-decomposable compound (C) or the compound (D) may first be dissolved, and then other components may be mixed. Otherwise, components other than the alkali-decomposable compound (C) or the compound (D) may be mixed and dissolved first, and then the alkali-decomposable compound (C) or the compound (D) may be mixed thereto. In the production of IC, the content of impurities such as trace amounts of metals in a material to be used, is desired to be as small as possible. Also with respect to the photoresist composition, in order to improve the purity, the respective constituting components may respectively be purified by e.g. an ion exchange method and then mixed to produce the photoresist composition, or the respective constituting components may be mixed to form a photoresist composition, which is then purified by e.g. an ion exchange method before use. When it is actually used for the production of integrated circuits, it is common to subject it to filtration by a filter with submicron pores before use.

Now, the present invention will be described in further detail with reference to Examples. However, it should be understood that the present invention is by no means restricted to such specific Examples. In the following Examples, the molecular weight represents a weight average molecular weight (the analytical value calculated as polystyrene, by a gel permeation chromatography method).

EXAMPLE 1

5.6504 g of a novolak resin (molecular weight: 4,000) (alkali-soluble resin (A)) produced from m-cresol, p-cresol and 2,5-xylenol (=5/4/1 (molar ratio)), and formaldehyde and acetaldehyde (=8/2 (molar ratio)), 4.2496 g of an esterified product (esterification rate: 28.2%) (radiation-sensitive compound (B)) of 1,2-naphthoquinonediazide-5-sulfonic acid of a condensation product (molecular weight: 1,074) of m-cresol with acetaldehyde, and 0.100 g of 2,2'-dihydroxy-2,2'-biindane-1,1',3,3'-tetoron (C1) as the alkali-decomposable compound (C) of the formula (I), were dissolved in a solvent mixture comprising 21 g of ethyl lactate and 9 g of propylene glycol monomethyl ether acetate. This solution was subjected to microfiltration by a Teflon filter having pores of 0.2 μm, to obtain photoresist composition 1. The results are shown in Table 2.

EXAMPLE 2

Photoresist composition 2 was prepared in the same manner as in Example 1 except that in Example 1, instead of the alkali-decomposable compound (C1), 2,2',3,3,3',3'-hexahydroxy-2,2'-biindane-1,1'-dione was used as (C2) to prepare the composition as identified in Table 1. The results are shown in Table 2.

EXAMPLE 3

4.7568 g of a novolak resin (molecular weight: 3,200) (alkali-soluble resin (A)) produced from m-cresol, p-cresol and 2,5-xylenol (=5/4/1 (molar ratio)), and formaldehyde and acetaldehyde (=8/2 (molar ratio)), 5.1432 g of an esterified product (esterification rate: 27.8%) (radiation-sensitive compound (B)) of 1,2-naphthoquinonediazide-5-sulfonic acid of a condensation product (molecular weight: 1,076) of m-cresol with acetaldehyde, and 0.100 g of 2,2'-dihydroxy-2,2'-biindane-1,1',3,3'-tetoron (C1) as the alkali-decomposable compound (C) of the formula (II), were dissolved in a solvent mixture comprising 21 g of ethyl lactate and 9 g of propylene glycol monomethyl ether acetate. This solution was subjected to microfiltration by a Teflon filter having pores of 0.2 μm, to obtain photoresist composition 6. The results are shown in Table 3.

COMPARATIVE EXAMPLE 1

Photoresist composition 3 was prepared in the same manner as in Example 1 except that in Example 1, the alkali-decomposable compound (C1) was not used, and the composition was as identified in Table 1.

COMPARATIVE EXAMPLE 2

Photoresist composition 4 was prepared in the same manner as in Example 1 except that in Example 1, instead of the alkali-decomposable compound (C1), 1,1,2,2-tetraphenyl-1,2-ethanediol was used, and the composition was as identified in Table 1.

COMPARATIVE EXAMPLE 3

Photoresist composition 5 was prepared in the same manner as in Example 1 except that in Example 1, instead of the alkali-decomposable compound (C1), 2,3,4,2',4'-pentahydroxybenzophenone was used, and the composition was as identified in Table 1.

COMPARATIVE EXAMPLE 4

Photoresist composition 7 was prepared in the same manner as in Example 3 except that in Example 3, instead of the alkali-decomposable compound (C1), 1,1,2,2-tetraphenyl-1,2-ethanediol was used, and the composition was as identified in Table 1.

COMPARATIVE EXAMPLE 5

Photoresist composition 8 was prepared in the same manner as in Example 3 except that in Example 3, instead of the alkali-decomposable compound (C1), 1,1,2,2-tetra(m-trifluoromethylphenyl)-1,2-ethanediol was used, and the composition was as identified in Table 1.

Evaluation method

Photoresist compositions 1 to 8 were respectively coated on silicon wafers by spin coating and then heated on a hot plate of 90°C for 60 minutes to remove the solvents to form photoresist coating films having a film thickness of 1.07 μm. They were exposed by an i-line stepper (NA. =0.50), manufactured by Nikon K.K., then heated on a hot plate of 110°C for 60 seconds, then immersed in a 2.38% tetramethylammonium hydroxide aqueous solution for 60 seconds for development. The cross sectional shapes of the formed patterns were inspected by an electron microscope, and the respective Eth, E0 and depth of focus were evaluated. At that time, the rectangularity in the cross-sectional shapes of the patterns (○ indicates that cross-sectional walls were vertical to the substrate, and X indicates that a T-top shape, an inverted taper shape, or a flared skirt or bite at the interface of the pattern with the substrate, was observed), and the presence or absence of a standing wave (a waving in the cross section of the patterns) was also evaluated. Further, the storage stability was evaluated (each photoresist composition was maintained at room temperature, and upon expiration of 6 months, the one having no insoluble matters formed in the photoresist liquid was evaluated to be good). The results are shown in Table 2 and Table 3. Also shown in Table 3 is the resolution power.

The coating films formed on silicon substrates from photoresist compositions of Examples 1 to 3 were subjected to heat treatment by a hot plate to evaluate sublimation properties of the photoresist compositions by collecting sublimed substances. However, no sublimed substances were detected with respect to any one of the photoresist compositions. In the same manner, the sublimation properties of the photoresist compositions having 2,3,4-trihydroxybenzophonone (3HBP) incorporated as an additive, were evaluated, whereby an amount corresponding to 10% of the incorporated 3HBP was detected as a sublimed substance.

Table 1

| | Alkali-soluble resin (A) | Radiation sensitive compound (B) | Alkali-decomposable compound (C) | Solvent | C/(A+B+C) ×100(%) |
|---|---|---|---|---|---|
| Examples 1 and 2 | 5.6504 | 4.2496 | 0.100 | 30.000 | 1.0 |
| Comparative Example 1 | 5.7504 | 4.2496 | - | 30.000 | - |
| Comparative Examples 2 and 3 | 5.6504 | 4.2496 | 0.100 | 30.000 | 1.0 |
| Example 3 | 4.7568 | 5.1432 | 0.100 | 30.000 | 1.0 |
| Comparative Examples 4 and 5 | 4.7568 | 5.1432 | 0.100 | 30.000 | 1.0 |

Table 2

| | | Eth (msec) | E0 (msec) | Depth of focus ($\mu m$) | Storage stability | Rectangularity |
|---|---|---|---|---|---|---|
| Example 1 | Photoresist composition 1 | 176 | 336 | 1.80 | Good | ○ |
| Example 2 | Photoresist composition 2 | 178 | 346 | 1.80 | Good | ○ |
| Comparative Example 1 | Photoresist composition 3 | 192 | 416 | 1.40 | Good | ○ |
| Comparative Example 2 | Photoresist composition 4 | 290 | 634 | 1.20 | Good | × |
| Comparative Example 3 | Photoresist composition 5 | 201 | 415 | 1.40 | Good | ○ |

Table 3

| | | Eth (msec) | E0 (msec) | Depth of focus ($\mu m$) | Resolution power ($\mu m$) | Storage stability | Standing wave |
|---|---|---|---|---|---|---|---|
| Example 3 | Photoresist composition 6 | 190 | 414 | 1.60 | 0.30 | Good | ○ |
| Comparative Example 4 | Photoresist composition 7 | 284 | 654 | 1.20 | 0.30 | Good | × |
| Comparative Example 5 | Photoresist composition 8 | 250 | 577 | 1.00 | 0.32 | Good | ○ |

The minimum exposure Eth at which the remaining photoresist film becomes 0, and the exposure E0 required for finish with a predetermined dimension, are regarded as indices for mass production influencing the throughput of microfabrication. For the production of semiconductors, the smaller, the better.

In Comparative Example 2, Eth and E0 were very large as compared with Examples 1 and 2, and the depth

of focus was also poor. Further, with respect to the rectangularity of the pattern, a bite was observed at the interface between the resist and the substrate.

In Comparative Examples 1 and 3 as compared with Examples 1 and 2, and in Comparative Examples 4 and 5 as compared with Example 3, Eth and E0 are large, and the depth of focus was also poor. Further, as compared with Example 3, in Comparative Example 4, a standing wave was observed, and in Comparative Example 5, the resolution power was poor.

EXAMPLE 4

5.8764 g of a novolak resin (molecular weight: 4,900) (alkali-soluble resin (A1)) produced from m-cresol, p-cresol and 2,5-xylenol (=5/4/1 (molar ratio)), and formaldehyde and acetaldehyde (=8/2 (molar ratio)), 4.4196 g of an esterified product (esterification rate: 29.0%) (radiation-sensitive compound (B1)) of 1,2-naphthoquinonediazide-5-sulfonic acid of a condensation product (molecular weight: 1,084) of m-cresol with acetaldehyde, and 0.104 g of 1,2,3-indantrione monohydrate (D1) as the compound (D), were dissolved in a solvent mixture comprising 23.8 g of 2-heptanone and 5.9 g of propylene glycol monomethyl ether. This solution was subjected to microfiltration by a Teflon filter having pores of 0.2 μm, to obtain photoresist composition 9, and the following evaluations were carried out. The results are shown in Table 5.

EXAMPLE 5

7.1323 g of a novolak resin (molecular weight: 3,500) (alkali-soluble resin (A2)) produced from m-cresol, p-cresol and 2,5-xylenol (=5/4/1 (molar ratio)), and formaldehyde and acetaldehyde (=8/2 (molar ratio)), 3.1637 g of an esterified product (esterification rate: 42%) (radiation-sensitive compound (B2)) of 1,2-naphthoquinonediazide-5-sulfonic acid of a condensation product (molecular weight: 950) of m-cresol with acetaldehyde and p-hydroxybenzaldehyde (=5/5) and 0.104 g of 1,2,3-indantrione monohydrate (D1) as the compound (D), were dissolved in a solvent mixture comprising 23.7 g of 2-heptanone and 5.9 g of propylene glycol monomethyl ether. The solution was subjected to microfiltration by a Teflon filter having pores of 0.2 μm, to obtain photoresist composition 10, and the evaluations were carried out. The results are shown in Table 6.

COMPARATIVE EXAMPLE 6

Photoresist composition 11 was prepared, and the evaluation was carried out, in the same manner as in Example 4 except that in Example 4, (D1) was not used as the compound (D), the composition was as identified in Table 4.

COMPARATIVE EXAMPLE 7

Photoresist composition 12 was prepared, and the evaluation was carried out, in the same manner as in Example 5 except that in Example 5, (D1) was not used as the compound (D), and the composition was as identified in Table 4.

<u>Evaluation method</u>

Photoresist compositions 9 to 12 were respectively coated on silicon wafers by spin coating and then heated on a hot plate of 90°C for 60 minutes to remove the solvents to form photoresist coating films having a film thickness of 1.07 μm. They were exposed by an i-line stepper (NA. =0.50), manufactured by Nikon K.K., then heated on a hot plate of 110°C for 60 seconds, then immersed in a 2.38% tetramethylammonium hydroxide aqueous solution for 60 seconds for development. The cross sectional shapes of the formed patterns were inspected by an electron microscope, and the respective Eth was evaluated. Further, E0 was measured at 0.4 μmL/S in Example 4 and at 0.6 μmL/S in Example 5, and the depth of focus was evaluated. At that time, the proximity effect (○ indicates "small", and X indicates "large") was evaluated. Further, the rectangularity in the cross-sectional shapes of the patterns (○ indicates that cross-sectional walls were vertical to the substrate, and X indicates that a T-top shape, an inverted taper shape, or a flared skirt or bite at the interface of the patterns with the substrate, was observed) was evaluated. Further, storage stability was evaluated (each photoresist composition was maintained at room temperature, and upon expiration of 6 months, the one having no insoluble matters formed in the photoresist liquid was evaluated to be good). The results are shown in Tables 5 and 6. Also shown in Table 5 are the resolution power and the exposure margin.

Table 4

| | | Alkali-soluble resin (A) (g) | Radiation sensitive compound (B) (g) | Compound (D) (g) | Solvent (g) | Blend ratio of compound (D) [D/(A+B+D) × 100] (%) |
|---|---|---|---|---|---|---|
| Example 4 | Photoresist composition 9 | 5.8764 | 4.4196 | 0.1040 | 29.6 | 1.0 |
| Example 5 | Photoresist composition 10 | 7.1323 | 3.1637 | 0.1040 | 29.6 | 1.0 |
| Comparative Example 6 | Photoresist composition 11 | 5.9804 | 4.4196 | - | 29.6 | - |
| Comparative Example 7 | Photoresist composition 12 | 7.2363 | 3.1637 | - | 29.6 | - |

Table 5

| | | Eth (msec) | E0 (msec) | Rectangularity | Storage stability | Exposure margins (E0/Ec) | Resolution power (μm) |
|---|---|---|---|---|---|---|---|
| Example 4 | Photoresist composition 9 | 280 | 558 | ○ | ○ | 1.49 | 0.30 |
| Comparative Example 6 | Photoresist composition 11 | 293 | 590 | × | ○ | 1.34 | 0.34 |

Table 6

| | | Eth (msec) | E0 (msec) | Depth of focus (μm) CD±5% | Proximity effect | Rectangularity | Storage stability |
|---|---|---|---|---|---|---|---|
| Example 5 | Photoresist composition 10 | 94 | 141 | 3.2 | ○ | ○ | ○ |
| Comparative Example 7 | Photoresist composition 12 | 110 | 173 | 2.4 | × | × | ○ |

The minimum exposure Eth at which the remaining photoresist film becomes 0, and the exposure E0 required for finish with a predetermined dimension, are regarded as indices for mass production influencing the throughput of microfabrication. For the production of semiconductors, the smaller, the better.

In Example 4, the exposure margin (E0/Ec) was 1.49, while in Comparative Example 6, it was 1.34. Further, with respect to the resolution power, it was 0.34 μm in Comparative Example 6. Whereas, in Example 4, a line and space of 0.30 μm was dissolved while the practical sensitivity (E0) was improved.

As compared with Comparative Example 7, in Example 5, the practical sensitivity (E0) was higher by at least 15%, and the proximity effect was also good. Further, in the depth of focus (CD-DOF: dimension±5%) taking the dimensional controllability into consideration, the one in Example 5 had a deeper depth of focus as compared with Comparative Example 7.

Further, in Examples 4 and 5, the storage stability was good.

As described in the foregoing, the photoresist composition of the present invention is excellent in rectangularity and has a high resolution, and not only that, it is excellent in other required properties. Accordingly, its significance in the lithography process is substantial as a means for microfabrication and high integration demanded in recent years. It is useful as a photoresist for preparing integrated circuits, particularly for microfabrication.

## Claims

1. A photoresist composition comprising:

   (1) an alkali-soluble resin (A),
   (2) a radiation sensitive compound (B), and
   (3) at least one member selected from the following compounds (C) and (D), as an additive:

   Compound (C): an alkali-decomposable compound which decomposes in the presence of an alkali to form water-soluble compounds; and
   Compound (D): a compound of the following formula (I):

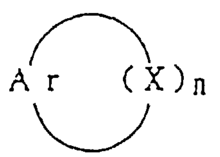

(I)

   wherein X is $-C(R^1)_2-$, -O-, =C=O, $=C(O(R^1))_2$, =S, =SO or $=SO_2$, $R^1$ is a hydrogen atom or a $C_{1-4}$ alkyl group, when a plurality of $R^1$ are present, they are the same or different, n is an integer of from 2 to 6, the plurality of X are the same or different, and Ar is a $C_{5-14}$ aryl group which is unsubstituted or substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when Ar has two or more substituents, such substituents are the same or different.

2. The photoresist composition according to Claim 1, wherein the weight average molecular weight (Mw) of at least one compound among the water-soluble compounds formed by decomposition of the alkali-decomposable compound (C) is $30 \leqq Mw \leqq 1000$.

3. The photoresist composition according to Claim 1, wherein the alkali-decomposable compound (C) is such that when it is added to 1,000 times by weight of a 2.38% tetramethylammonium hydroxide (TMAH) aqueous solution at 23°C, at least 3 wt% of its initially added amount decomposes in 60 seconds.

4. The photoresist composition according to Claim 1, which has an exposure range in which the dissolving rate at a dissolving site during development of the photoresist composition is at least 1.05 times the dissolving rate of the corresponding composition in which the alkali-decomposable compound (C) or the compound (D) is not incorporated.

5. The photoresist composition according to Claim 1, wherein the alkali-decomposable compound (C) is one which, upon decomposition in the presence of an alkali, forms at least the compound of the formula (I).

6. The photoresist composition according to Claim 1, wherein the alkali-decomposable compound (C) is represented by the following formula (II) or (III):

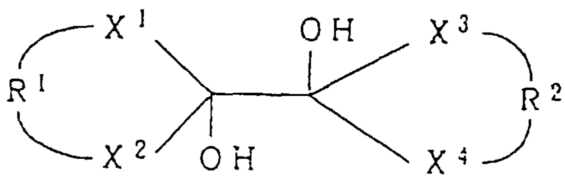

(II)

wherein each of $X^1$ to $X^4$ which is the same or different, is $-C(R^3)_2-$, -O-, =C=O, $=C(O(R^3))_2$, =S, =SO, $=SO_2$ or $=NR^3$, $R^3$ is a hydrogen atom or a $C_{1-4}$ alkyl group, and each of $R^1$ and $R^2$ is a $C_{5-14}$ aryl group which is unsubstituted or substituted by a hydroxyl group, a halogen atom, an alkyl group, a cycloalkyl group, an alkoxy group, an alkenyl group, an aryl group, an aralkyl group, an alkoxycarbonyl group, an alkylcarbonyloxy group, an aryloxycarbonyl group or an arylcarbonyloxy group, provided that when $R^1$ or $R^2$ has two or more substituents, such substituents are the same or different,

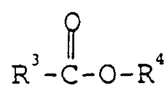

(III)

wherein each of $R^3$ and $R^4$ is a $C_{1-4}$ alkyl group or a $C_{5-14}$ aryl group, which is unsubstituted or substituted by a hydroxyl group, a halogen atom, a cyano group, a nitro group, an alkyl group (excluding substitution on the alkyl group), a cycloalkyl group, an alkoxy group, an alkenyl group, an aryl group, an aralkyl group, an alkoxycarbonyl group, an alkoxycarbonyloxy group, an aryloxycarbonyl group or an arylcarbonyloxy group, provided that when $R^3$ or $R^4$ has two or more substituents, such substituents are the same or different.

7. The photoresist composition according to Claim 1, which contains the alkali-decomposable compound (C) in an amount of from 0.1 to 10 wt%, based on the solid content of the photoresist composition.

8. The photoresist composition according to Claim 1, wherein in the formula (I), Ar is a $C_6$ aryl group which is unsubstituted or substituted.

9. The photoresist composition according to Claim 1, wherein in the formula (I), X is $-C(R^1)_2-$, -O-, =C=O or $=C(O(R^1))_2$.

10. The photoresist composition according to Claim 1, wherein the compound (D) is 1,2,3-indantrione or 1,2,3-indantrione monohydrate.

11. The photoresist composition according to Claim 1, which contains the compound (D) in an amount of from 0.1 to 20 wt%, based on the solid content of the photoresist composition.